# EUROPÄISCHE PATENTANMELDUNG

(11) **EP 1 077 592 A1**
(43) Veröffentlichungstag der Anmeldung: **21.02.2001**
(21) Anmeldenummer: 99115199.4
(22) Anmeldetag: 17.08.1999
(51) Int. Cl.: H05K 13/04

(54) **Bauteiltransporteinheit**

(71) Anmelder: SiMoTec GmbH, 82041 Oberhaching (DE)
(72) Erfinder: Feraric, Johann, Dr., 85579 Neubiberg (DE); Fischer, Jakob, 82008 Unterhaching (DE)
(74) Vertreter: Hofstetter, Alfons J., Dr.rer.nat.

(57) **Zusammenfassung**

Die vorliegende Erfindung betrifft eine Bauteiltransporteinheit, insbesondere für vollautomatische Montagevorrichtungen zur Herstellung mikrosystemtechnischer Produkte sowie für Montageaufgaben in der Halbleiterindustrie, mit mindestens einem Montagekopf (12), wobei die Bauteiltransporteinheit (10) mindestens eine bildgebende Vorrichtung (14) sowie mindestens einen Aktor (16) zur Behebung und zum Ausgleich translatorischer Fehler der Bauteiltransporteinheit (10) aufweist. Des weiteren wird ein Verfahren zur Herstellung mikrosystemtechnischer Produkte mittels einer vollautomatischen Montagevorrichtung mit mindestens einer erfindungsgemäßen Bauteiltransporteinheit (10) vorgestellt.

## Beschreibung

Die vorliegende Erfindung betrifft eine Bauteiltransporteinheit, insbesondere für vollautomatische Montagevorrichtungen zur Herstellung mikrosystemtechnischer Produkte sowie für Montageaufgaben in der Halbleiterindustrie, mit mindestens einem Montagekopf. Die Erfindung betrifft zudem ein Verfahren zur Herstellung mikrosystemtechnischer Produkte mittels einer vollautomatischen Montagevorrichtung mit mindestens einer Bauteiltransporteinheit.

Bei der Herstellung mikrosystemtechnischer Produkte hat die Präzisions- und Mikromontage eine entscheidende Bedeutung im Produktionsprozeß. Bisher bekannte gattungsgemäße Bauteiltransporteinheiten beziehungsweise Montagevorrichtungen mit Bauteiltransporteinheiten erreichen die gestellten Präzisionsanforderungen nur durch den Einsatz teurer mechanischer Präzisionskomponenten sowie durch eine extrem steife Auslegung der tragenden Bauteile. Die Verfahrgeschwindigkeiten der bekannten Bauteiltransporteinheiten sind begrenzt, um keine störenden Maschinenschwingungen zu induzieren. Zudem erfolgt die Plazierbewegung rein gesteuert, d. h. ohne fortlaufende Kontrolle während der Bauteilablage. Aus diesen Gründen ergeben sich nachteiligerweise hohe Maschinenpreise bei gleichzeitig geringem Maschinendurchsatz und relativ ungenauem Montageergebnis.

Es ist daher Aufgabe der vorliegenden Erfindung, eine Bauteiltransporteinheit der eingangs genannten Art bereitzustellen, die eine exakte Regelung und Steuerung gewährleistet und kostengünstig herstellbar ist.

Es ist weiterhin Aufgabe der vorliegenden Erfindung, ein Verfahren der eingangs genannten Art bereitzustellen, welches eine schnelle und exakte Positionierung von Bauteilen bei der Herstellung mikrosystemtechnischer Produkte erlaubt.

Zur Lösung dieser Aufgaben dienen eine Bauteiltransporteinheit mit den Merkmalen des Anspruches 1 sowie ein Verfahren mit den Merkmalen des Anspruches 11.

Vorteilhafte Ausgestaltungen sind in den Unteransprüchen beschrieben.

Eine erfindungsgemäße Bauteiltransporteinheit weist mindestens eine bildgebende Vorrichtung sowie mindestens einen Aktor zur Behebung und zum Ausgleich translatorischer Fehler der Bauteiltransporteinheit auf. Dadurch ist eine aktive Ausregelung der auftretenden Montageabweichungen gewährleistet. Durch die Anordnung des Aktors an der Bauteiltransporteinheit ist zudem gewährleistet, daß eine Trennung der reinen Transportbewegung durch die Montagevorrichtung von der eigentlichen Positionierbewegung der Bauteiltransporteinheit beziehungsweise eines Montagekopfs der Bauteiltransporteinheit erfolgen kann. Dadurch ist wiederum gewährleistet, daß der hochpräzise Positioniervorgang, der sehr genau und langsam erfolgen muß, von den in der Regel schnell und dafür relativ ungenau auszuführenden Transportbewegungen unabhängig ist. Dadurch ist eine höhere Montagepräzision bei gleichzeitig höherem Durchsatz und deutlich geringeren Maschinenherstellkosten erreichbar.

In einer vorteilhaften Ausgestaltung der Erfindung ist die bildgebende Vorrichtung im oder am Montagekopf integriert. Die bildgebende Vorrichtung kann aber auch separat vom Montagekopf angeordnet sein. Durch die bildgebende Vorrichtung ist eine Lage- und Positionsmessung relativ zum Zielpunkt, d. h. zum Bauteil oder zu einem Montageort des Bauteils, kontinuierlich möglich. Üblicherweise ist die bildgebende Vorrichtung eine Kamera.

In einer weiteren vorteilhaften Ausgestaltung der Erfindung besteht der Aktor aus mindestens einer aktiv geregelten Positioniervorrichtung und mindestens einer Ausgleichsvorrichtung zur Entkoppelung von Vibrationen der Bauteiltransporteinheit sowie der gesamten Montagevorrichtung. Durch die aktiv geregelte Positioniereinheit ist eine Feinstpositionierung des Montagekopfs beziehungsweise der Bauteiltransporteinheit gewährleistet. Die Positionierpräzision wird durch den Einsatz der Ausgleichsvorrichtung deutlich erhöht.

In einer vorteilhaften Ausgestaltung der Erfindung besteht die Positioniervorrichtung aus drei Piezoelementen, wobei jedes Piezoelement in einer unterschiedlichen Raumachse x, y oder z beweglich ausgebildet ist, und die Raumachsen x, y, z jeweils senkrecht zueinander ausgerichtet sind. Die Verwendung von Piezoelementen zur Positionierung der Bauteiltransporteinheit beziehungsweise des Montagekopfes erlaubt eine Handhabung der zu greifenden Bauteile mit einer Wiederholgenauigkeit von ≤ 1 µm. Zudem arbeitet eine derartige Positioniervorrichtung verzögerungsfrei und ist besonders reaktionsschnell.

In einer weiteren vorteilhaften Ausgestaltung der Erfindung besteht die Ausgleichsvorrichtung aus einem geregelten Kardan-Gelenk, wobei das Kardan-Gelenk zur Schwingungskompensation angetriebene x-, y-, z-Achsen aufweist. Des weiteren weist das Kardan-Gelenk vorteilhafterweise Positions- und Drehratensensoren auf. Dadurch wird eine stabilisierte Plattformkomponente zur Entkoppelung der Maschinenvibrationen bereitgestellt, die auf Basis von Drehraten- und Positionsmessungen entsprechende Ausgleichsbewegungen ausübt.

In weiteren vorteilhaften Ausgestaltungen der erfindungsgemäßen Bauteiltransporteinheit kann der Montagekopf aus einem Greifwerkzeug, einem vertikal oder horizontal angeordneten Revolverkopf bestehen.

Bei einem erfindungsgemäßes Verfahren zur Herstellung mikrosystemtechnischer Produkte mittels einer vollautomatischen Montagevorrichtung mit mindestens einer Bauteiltransporteinheit wird abhängig von der Lage der Bauteiltransporteinheit relativ zu einem Bauteil oder zu einem Montageort ein Steuerungs- oder ein Regelungsmodus aktiviert.

Das Verfahren umfaßt dabei folgende Schritte:
a) Positionierung der Bauteiltransporteinheit ausreichend genau relativ zum Bauteil mittels gesteuerter, rascher Transportbewegung und Greifen des Bauteils mit einem Montagekopf bzw. einem daran angeordneten Greifwerkzeug,
b) Verfahren der Bauteiltransporteinheit mit dem Bauteil zu einem vorbestimmten Montageort mittels rascher, gesteuerter Transportbewegung,
c) Bestimmung der Lage des gegriffenen Bauteils relativ zum Montagekopf bzw. dem Greifwerkzeug während des Transportvorgangs gemäß Verfahrensschritt b) und Speicherung der Werte des ermittelten translatorischen und rotatorischen Versatzes als Korrekturinformation für die nach dem Transportvorgang gemäß Verfahrensschritt b) im Verfahrensschritt e) erfolgende Bauteilablage,
d) Positionierung der Bauteiltransporteinheit relativ zum Montageort mittels einer bildgebenden Vorrichtung und Umschalten in einen Regelmodus, d.h. Aktivierung eines Aktors sowie Speicherung der ermittelten Werte der Reativlage der Bauteiltransporteinheit als Korrekturinformation für die im Verfahrensschritt e) erfolgende Bauteilablage,
e) Ablage des Bauteils unter fortwährender Kontrolle der Relativlage der Bauteiltransporteinheit und des Bauteils zum Montageort und Ausgleich möglicher Lageabweichungen mittels des Aktors, und
f) Umschalten in einen Steuermodus und Positionierung der Bauteiltransporteinheit gemäß Verfahrensschritt a).

In einer vorteilhaften Weiterbildung des erfindungsgemäßen Verfahrens besteht im Verfahrensschritt e) eine Ausgleichsvorrichtung des Aktors aus einem geregelten Kardan-Gelenk, wobei zur Vermeidung von Lagefehlern durch Maschinenvibrationen die Drehraten und rotorischen Positionen am Kardan-Gelenk gemessen werden und durch entsprechende Motoren kompensiert werden.

Weitere Einzelheiten, Merkmale und Vorteile der Erfindung ergeben sich aus einem im folgenden beispielhaft dargestellten Ausführungsbeispiel.

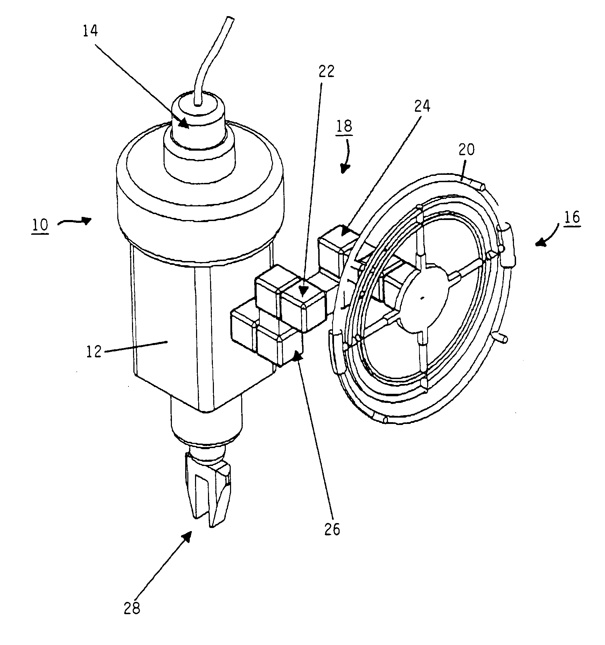

Die Figur zeigt eine Bauteiltransporteinheit 10 mit einem Montagekopf 12, einer bildgebenden Vorrichtung 14 sowie einem Aktor 16 zur Behebung und zum Ausgleich translatorischer Fehler der Bauteiltransporteinheit 10. Die bildgebende Vorrichtung 14 ist dabei im Montagekopf 12 integriert und besteht aus einer Kamera. Der Aktor 16 besteht aus einer aktiv geregelten Positioniervorrichtung 18 und einer Ausgleichsvorrichtung 20 zur Entkoppelung von Vibrationen der Bauteiltransporteinheit 10 sowie der gesamten Montagevorrichtung (nicht dargestellt).

Die Positioniervorrichtung 18 besteht dabei aus drei Piezoelementen 22, 24, 26, wobei jedes Piezoelement 22, 24, 26 in einer unterschiedlichen Raumachse x, y oder z beweglich ausgebildet ist und die Raumachsen x, y, z jeweils senkrecht zueinander sind.

Des weiteren erkennt man, daß die Ausgleichsvorrichtung 20 aus einem geregelten Kardan-Gelenk besteht. Das Kardan-Gelenk weist dabei zur Schwingungskompensation angetriebene x-, y-, z-Achsen auf. Zudem sind Positions- und Drehratensensoren (nicht dargestellt) ausgebildet.

Des weiteren erkennt man, daß der Montagekopf ein Greifwerkzeug 28 aufweist.

Zu den Anwendungsbereichen der Bauteiltransporteinheit 10 gehören unter anderem die Bestückung von Leiterplatten, die Herstellung mikrosystemtechnischer Produkte sowie weitere Montageaufgaben in der Halbleiterindustrie und verwandten Industriebereichen.

## Patentansprüche

1. Bauteiltransporteinheit, insbesondere für vollautomatische Montagevorrichtungen zur Herstellung mikrosystemtechnischer Produkte sowie für Montageaufgaben in der Halbleiterindustrie, mit mindestens einem Montagekopf (12),
**dadurch gekennzeichnet,**
daß die Bauteiltransporteinheit (10) mindestens eine bildgebende Vorrichtung (14) sowie mindestens einen Aktor (16) zur Behebung und zum Ausgleich translatorischer Fehler der Bauteiltransporteinheit (10) aufweist.

2. Bauteiltransporteinheit nach Anspruch 1,
**dadurch gekennzeichnet,**
daß die bildgebende Vorrichtung (14) im oder am Montagekopf (12) integriert ist.

3. Bauteiltransporteinheit nach Anspruch 1,
**dadurch gekennzeichnet,**
daß die bildgebende Vorrichtung (14) separat vom Montagekopf (12) angeordnet ist.

4. Bauteiltransporteinheit nach einem der vorhergehenden Ansprüche,
**dadurch gekennzeichnet,**
daß der Aktor (16) aus mindestens einer aktiv geregelten Positioniervorrichtung (18) und mindestens einer Ausgleichsvorrichtung (20) zur Entkoppelung von Vibrationen der Bauteiltransporteinheit (10) sowie der gesamten Montagevorrichtung, besteht.

5. Bauteiltransporteinheit nach Anspruch 4,
**dadurch gekennzeichnet,**
daß die Positioniervorrichtung (18) aus drei Piezoelementen (22, 24, 26) besteht, wobei jedes Piezoelement (22, 24, 26) in einer unterschiedlichen Raumachse x, y oder z beweglich ausgebildet ist und die Raumachsen x, y, z jeweils senkrecht zueinander ausgerichtet sind.

6. Bauteiltransporteinheit nach Anspruch 4 oder 5,
**dadurch gekennzeichnet,**
daß die Ausgleichsvorrichtung (20) aus einem geregelten Kardan-Gelenk besteht.

7. Bauteiltransporteinheit nach Anspruch 6,
**dadurch gekennzeichnet,**
daß das Kardan-Gelenk zur Schwingungskompensation angetriebene x-, y-, z-Achsen aufweist.

8. Bauteiltransporteinheit nach einem der Ansprüche 1 bis 7,
**dadurch gekennzeichnet,**
daß das Kardan-Gelenk Positions- und Drehratensensoren aufweist.

9. Bauteiltransporteinheit nach einem der vorhergehenden Ansprüche,
**dadurch gekennzeichnet,**
daß der Montagekopf (12) ein Greifwerkzeug (28) aufweist.

10. Bauteiltransporteinheit nach einem der Ansprüche 1 bis 8,
**dadurch gekennzeichnet,**
daß der Montagekopf (12) einen vertikal oder horizontal angeordneten Revolverkopf aufweist.

11. Verfahren zur Herstellung mikrosystemtechnischer Produkte mittels einer vollautomatischen Montagevorrichtung mit mindestens einer Bauteiltransporteinheit (10) nach einem der vorhergehenden Ansprüche,
**dadurch gekennzeichnet,**
daß abhängig von der Lage der Bauteiltransporteinheit (10) relativ zu einem Bauteil oder zu einem Montageort ein Steuerungs- oder ein Regelungsmodus aktiviert wird.

12. Verfahren nach Anspruch 11,
**dadurch gekennzeichnet,**
daß das Verfahren folgende Schritte umfaßt:
a) Positionierung der Bauteiltransporteinheit (10) ausreichend genau relativ zum Bauteil mittels gesteuerter, rascher Transportbewegung und Greifen des Bauteils mit einem Montagekopf (12) bzw. einem daran angeordneten Greifwerkzeug (28),
b) Verfahren der Bauteiltransporteinheit (10) mit dem Bauteil zu einem vorbestimmten Montageort mittels rascher, gesteuerter Transportbewegung,
c) Bestimmung der Lage des gegriffenen Bauteils relativ zum Montagekopf (12) bzw. dem Greifwerkzeug (28) während des Transportvorgangs gemäß Verfahrensschritt b) und Speicherung der Werte des ermittelten translatorischen und rotatorischen Versatzes als Korrekturinformation für die nach dem Transportvorgang gemäß Verfahrensschritt b) im Verfahrensschritt e) erfolgende Bauteilablage,
d) Positionierung der Bauteiltransporteinheit (10) relativ zum Montageort mittels einer bildgebenden Vorrichtung (14) und Umschalten in einen Regelmodus, d.h. Aktivierung eines Aktors (16) sowie Speicherung der ermittelten Werte der Reativlage der Bauteiltransporteinheit (10) als Korrekturinformation für die im Verfahrensschritt e) erfolgende Bauteilablage,
e) Ablage des Bauteils unter fortwährender Kontrolle der Relativlage der Bauteiltransporteinheit (10) und des Bauteils zum Montageort und Ausgleich möglicher Lageabweichungen mittels des Aktors (16), und
f) Umschalten in einen Steuermodus und Positionierung der Bauteiltransporteinheit (10) gemäß Verfahrensschritt a).

13. Verfahren nach Anspruch 12,
**dadurch gekennzeichnet,**
daß im Verfahrensschritt e) eine Ausgleichsvorrichtung (20) des Aktors (16) aus einem geregelten Kardan-Gelenk besteht und zur Vermeidung von Lagefehlern durch Maschinenvibrationen die Drehraten und rotorischen Positionen am Kardan-Gelenk gemessen und durch entsprechende Motoren kompensiert werden.
